# EUROPÄISCHE PATENTANMELDUNG

(11) **EP 1 455 181 A1**
(43) Veröffentlichungstag der Anmeldung: **08.09.2004**
(21) Anmeldenummer: 03405087.2
(22) Anmeldetag: 14.02.2003
(51) Int. Cl.: G01N 27/20, G01R 27/02

(54) **Verfahren zum zerstörungsfreien Prüfen von Verbundstromschienen**

(71) Anmelder: Alcan Technology & Management Ltd., 8212 Neuhausen am Rheinfall (CH)
(72) Erfinder: Netzel, Timo, 06844 Dessau (DE); Spörndli, Rudolf, 8224 Löhningen (CH)

(57) **Zusammenfassung**

Bei einem Verfahren zum zerstörungsfreien Prüfen der Qualität der Verbindung (16) zwischen einem Tragkörper (12) und einer bandförmigen Auflage (14) einer Verbundstromschiene (10) wird der elektrische Widerstand (Rᵥ) zwischen einem ersten Messpunkt (P₁) auf der Tragkörperoberfläche und einem in Längsrichtung (x) der Verbundstromschiene (10) in einem Abstand (a) zum ersten Messpunkt (P₁) liegenden zweiten Messpunkt (P₂) auf der Lauffläche der bandförmigen Auflage (14) und der elektrische Widerstand (R_{B}) zwischen dem ersten Messpunkt (P₁) und einem in Längsrichtung (x) der Verbundstromschiene (10) in gleichem Abstand a zum ersten Messpunkt (P₁) auf der Tragkörperoberfläche liegenden dritten Messpunkt (P₃) gemessen. Das Verhältnis R_{V}/R_{B} wird als Gütefaktor für die Beurteilung der Qualität der Verbindung (16) zwischen dem Tragkörper (12) und der bandförmigen Auflage (14) in dem durch den Abstand (a) definierten Abschnitt der Verbundstromschiene (10) verwendet.

## Beschreibung

Die Erfindung betrifft ein Verfahren zum zerstörungsfreien Prüfen der Qualität der Verbindung zwischen einem Tragkörper und einer bandförmigen Auflage einer Verbundstromschiene, bei welchem Verfahren der elektrische Widerstand R_{V} zwischen einem ersten Messpunkt auf der Tragkörperoberfläche und einem zweiten Messpunkt auf der Lauffläche der bandförmigen Auflage gemessen wird und der Messwert als Kenngrösse für die Verbindungsqualität dient.

Verbundstromschienen bestehen im allgemeinen aus einem den elektrischen Strom leitenden Tragkörper aus Aluminium mit einer verschleissarmen bandförmigen Auflage aus nichtrostendem Stahl. Zur Stromabnahme schleifen im Betrieb elektrische Stromabnehmer auf der Stahlbandauflage der Verbundstromschiene. Die Qualität der Grenzfläche zwischen dem Tragkörper und der Auflage bestimmt den Verbindungs- oder Übergangswiderstand und damit die Höhe eines allfälligen Stromverlustes bei Fehlern in der Verbundhaftung.

Zur Prüfung der Qualität der Verbindung zwischen Tragkörper und bandförmiger Auflage einer Verbundstromschiene ist es aus der DE-C 44 01 484 bekannt, den elektrischen Verbindungswiderstand zu messen und den Messwert als Kenngrösse für die Verbindungsqualität heranzuziehen. Die für die Widerstandsmessung festgelegten Messpunkte liegen jeweils in einer senkrecht zur Längsrichtung der Verbundstromschiene angeordneten Ebene. Der Nachteil dieser Anordnung der Messpunkte liegt darin, dass sich der gemessene elektrische Widerstandswert auf einen lokal eng begrenzten Abschnitt im Bereich der Messpunkte bezieht. Wird die Messung in einem gewissen Abstand in Längsrichtung der Verbundstromschiene wiederholt, so kann es vorkommen, dass eine zwischen den beiden Messstellen liegende fehlerhafte Verbindungsstelle nicht entdeckt wird.

Der Erfindung liegt die Aufgabe zugrunde, ein Verfahren der eingangs genannten Art so zu verbessern, dass die den Verfahren nach dem Stand der Technik anhaftenden Nachteile nicht mehr auftreten.

Zur erfindungsgemässen Lösung der Aufgabe führt, dass der zweite Messpunkt in Längsrichtung der Verbundstromschiene in einem Abstand zum ersten Messpunkt liegt, der elektrische Widerstand R_{B} zwischen dem ersten Messpunkt und einem in Längsrichtung der Verbundstromschiene in gleichem Abstand zum ersten Messpunkt auf der Tragkörperoberfläche liegenden dritten Messpunkt gemessen und das Verhältnis R_{V}/R_{B} als Gütefaktor für die Beurteilung der Qualität der Verbindung zwischen dem Tragkörper und der bandförmigen Auflage in dem durch den Abstand a definierten Abschnitt der Verbundstromschiene verwendet wird.

Mit der erfindungsgemässen Anordnung der in Längsrichtung der Verbundstromschiene voneinander beabstandeten Messpunkte lässt sich eine Aussage zur Verbindungsqualität eines ganzen Abschnittes einer Verbundstromschiene machen. Wird bei jeder nachfolgenden Messung darauf geachtet, dass der neue erste Messpunkt dem vorangehenden zweiten Messpunkt entspricht oder diesen überschneidet, so kann mit einer minimalen Anzahl von Messungen eine lückenlose Überprüfung der Verbundstromschiene durchgeführt werden.

Der in der Praxis bevorzugte Abstand zwischen dem ersten Messpunkt und dem zweiten bzw. dritten Messpunkt beträgt 20 bis 120 cm, insbesondere 40 bis 90 cm.

In gewissen Fällen kann es zweckmässig sein, auch die Breite der Auflage zu berücksichtigen und mehrere Messpunkte über die Breite der Auflage verteilt anzuordnen.

Das erfindungsgemässe Verfahren eignet sich insbesondere zum Prüfen einer Verbundstromschiene mit einem Tragkörper aus Aluminium und einer bandförmigen Auflage aus nichtrostendem Stahl.

Weitere Vorteile, Merkmale und Einzelheiten der Erfindung ergeben sich aus der nachfolgenden Beschreibung eines bevorzugten Ausführungsbeispiels sowie anhand der Zeichnung; diese zeigt schematisch in
- Fig. 1 eine Schrägsicht auf eine Verbundstromschiene;
- Fig. 2 eine Anordnung zum Messen des elektrischen Widerstandes.

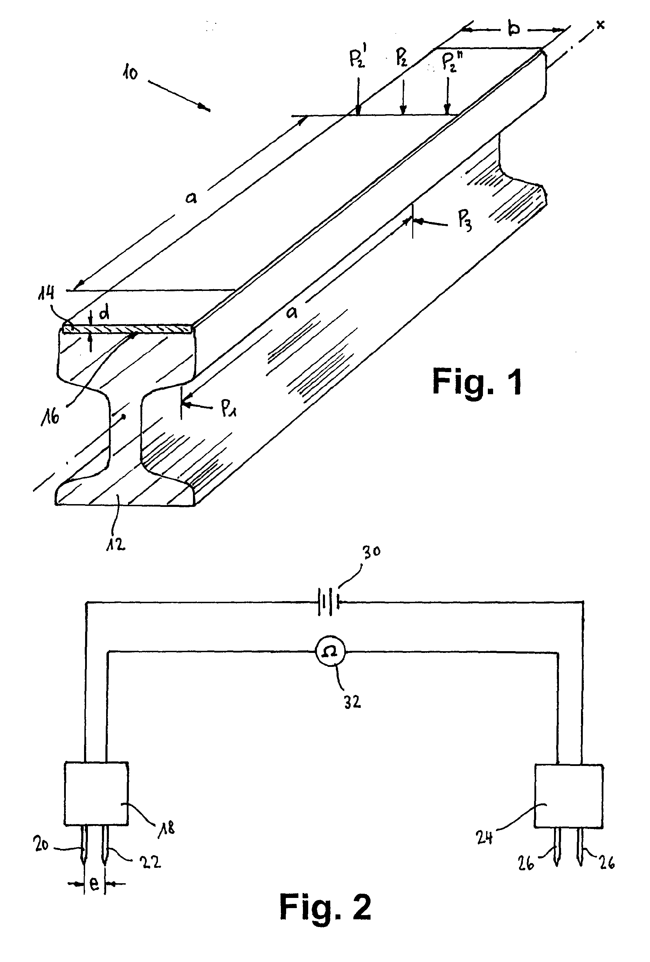

Eine in Fig. 1 gezeigte Verbundstromschiene 10 weist einen Tragkörper 12 aus Aluminium mit einer Auflage 14 aus nichtrostendem Stahl auf. Die Breite b der Stahlbandauflage 14 beträgt beispielsweise 80 mm, die Dicke d beispielsweise 6 mm. Eine Herstellungsart der Verbundstromschiene 10 ist beispielsweise in der DE-C- 24 32 541 offenbart.

In der Praxis übernimmt der Tragkörper 12 den Hauptteil der Stromleitung in der Längsrichtung x der Verbundstromschiene 10 und die Stromentnahme aus der Verbundstromschiene 10 erfolgt lokal vom Tragkörper 12 durch die Auflage 14 hindurch über einen auf der Auflage 14 schleifenden elektrischen Stromabnehmer. Die Qualität der Verbindung 16 beim Übergang vom Tragkörper 12 zur Auflage 14 ist entscheidend für den Übergangswiderstand und mit diesem verbundene allfällige Stromverluste.

Zur Bestimmung eines sich auf einen Abschnitt der Verbundstromschiene 10 beziehenden Gütefaktors für die Beurteilung der Qualität der Verbindung zwischen dem Tragkörper 12 und der bandförmigen Auflage 14 sind drei Messpunkte erforderlich. Der erste Messpunkt P₁ befindet sich seitlich auf der Oberfläche des Tragkörpers 12. Der zweite Messpunkt P₂ befindet sich in Längsrichtung x der Verbundstromschiene 10 in einem Abstand a von beispielsweise 50 cm zum ersten Messpunkt P₁ auf der Oberfläche der bandförmigen Stahlauflage 14. Dieser zweite Messpunkt P₂ kann zusätzlich über die Breite b der Auflage 14 variieren. In Fig. 1 sind neben dem mittigen Messpunkt P₂ noch zwei randständige Messpunkte P₂' und P₂" dargestellt.

Seitlich auf der Oberfläche des Tragkörpers 12 und in Laufrichtung x der Verbundstromschiene 10 im Abstand a zum ersten Messpunkt P₁ liegt der dritte Messpunkt P₃.

Die in Fig. 2 dargestellte Messanordnung zur Bestimmung elektrischer Widerstände umfasst zwei Messfühler 18, 24 mit je zwei Messstiften 20, 22 bzw. 26, 28. Die Messstifte 20, 22 und 26, 28 jedes Messfühlers 18, 24 sind in einem gegenseitigen Abstand e von beispielsweise 5 mm angeordnet. Die Messstifte 20, 22 und 26, 28 sind im Messfühler 18, 24 in Stiftrichtung federnd gelagert. In der Zeichnung nicht dargestellt sind Klemmhalterungen, mit denen die Messfühler 18, 24 so an der Verbundstromschiene 10 festklemmbar sind, dass die Messstifte bei den Messpunkten mit gleichbleibender Kraft den Kontakt zur Oberfläche des Tragkörpers 12 bzw. der Auflage 14 herstellen.

Die Messung des elektrischen Widerstandes zwischen den Messpunkten P₁ und P₂ bzw. P₁ und P₃ erfolgt in bekannter Weise so, dass zwischen je einem Messstift 22, 26 durch Anschluss an eine Stromquelle 30 ein Stromfluss erzeugt wird. Über ein Präzisionswiderstandsmessgerät (Ohmmeter) 32 wird über die Messung des zwischen den beiden Messpunkten auftretenden Spannungsabfalls der elektrische Widerstand berechnet. Hierbei bezieht sich der zwischen dem ersten Messpunkt P₁ und dem zweiten Messpunkt P₂ gemessene elektrische Widerstand auf den Verbindungs- oder Übergangswiderstand zwischen dem Tragkörper 12 und der Auflage 14. Der elektrische Widerstand zwischen dem ersten Messpunkt P₁ und dem dritten Messpunkt P₃ entspricht dem elektrischen Widerstand des Tragkörpers 12 in einem Abschnitt der Verbundstromschiene 10 einer dem Abstand zwischen den Messpunkten P₁ und P₂ bzw. P₁ und P₃ entsprechenden Länge a und wird hier deshalb als Bezugswiderstand R_{B} bezeichnet.

In zwei Messungen wird der elektrische Widerstand zwischen den Punkte P₁ und P₂ und P₁ und P₃ gemessen. Das Verhältnis R_{V}/R_{B} definiert den Gütefaktor. Ein niedriger Wert des Gütefaktors weist auf eine hohe Qualität der Verbindung zwischen Tragkörper 12 und Auflage 14 hin, während eine Zunahme der Grösse des Gütefaktors eine abnehmende Verbindungsqualität bedeutet. In der Praxis kann zur Qualitätskontrolle beispielsweise ein Gütefaktor 3 als Grenzwert festgelegt werden.

Zur Veranschaulichung sind in der nachfolgenden Tabelle die an einer Verbundschiene aus Aluminium mit Stahlbandauflage bei einem Abstand a der Messfühler von 500 mm die gemessenen Werte für den Bezugswiderstand R_{B}, den Verbindungswiderstand R_{V} und der daraus errechnete Wert für den Gütefaktor R_{V}/R_{B} zusammengestellt. Der zweite Messpunkt P₂ wurde über die Breite der Stahlbandauflage variiert (links-Mitte-rechts). Es wurden nacheinander zwei Messungen durchgeführt.

| Bezugswiderstand R_{B} [µOhm] | Verbindungswiderstand R_{V} [µOhm] | | | Gütefaktor R_{V}/R_{B} | | |
|---|---|---|---|---|---|---|
| | links | Mitte | rechts | links | Mitte | rechts |
| 3.4 | 4.6 | 4.6 | 5.6 | 1.35 | 1.35 | 1.64 |
| 3.4 | 4.6 | 4.7 | 5.7 | 1.35 | 1.38 | 1.67 |

## Patentansprüche

1. Verfahren zum zerstörungsfreien Prüfen der Qualität der Verbindung (16) zwischen einem Tragkörper (12) und einer bandförmigen Auflage (14) einer Verbundstromschiene (10), bei welchem Verfahren der elektrische Widerstand (R_{V}) zwischen einem ersten Messpunkt (P₁) auf der Tragkörperoberfläche und einem zweiten Messpunkt (P₂) auf der Lauffläche der bandförmigen Auflage (14) gemessen wird und der Messwert als Kenngrösse für die Verbindungsqualität dient,
**dadurch gekennzeichnet, dass**
der zweite Messpunkt (P₂) in Längsrichtung (x) der Verbundstromschiene (10) in einem Abstand a zum ersten Messpunkt (P₁) liegt, der elektrische Widerstand (R_{B}) zwischen dem ersten Messpunkt (P₁) und einem in Längsrichtung (x) der Verbundstromschiene (10) in gleichem Abstand a zum ersten Messpunkt (P₁) auf der Tragkörperoberfläche liegenden dritten Messpunkt (P₃) gemessen und das Verhältnis R_{V}/R_{B} als Gütefaktor für die Beurteilung der Qualität der Verbindung (16) zwischen dem Tragkörper (12) und der bandförmigen Auflage (14) in dem durch den Abstand a definierten Abschnitt der Verbundstromschiene (10) verwendet wird.

2. Verfahren nach Anspruch 1, **dadurch gekennzeichnet, dass** der Abstand (a) zwischen dem ersten Messpunkt (P₁) und dem zweiten (P₂) bzw. dritten Messpunkt (P₃) 20 bis 120 cm, vorzugsweise 40 bis 90 cm beträgt.

3. Verfahren nach Anspruch 1 oder 2, **dadurch gekennzeichnet, dass** der zweite Messpunkt (P₂) mehreren über die Breite (b) der bandförmigen Auflage (14) verteilten Messpositionen (P₂, P₂', P₂") zugeordnet wird.

4. Anwendung des Verfahrens nach einem der vorangehenden Ansprüche zum Prüfen einer Verbundstromschiene (10) mit einem Tragkörper (12) aus Aluminium und einer bandförmigen Auflage (14) aus nichtrostendem Stahl.
